# EUROPEAN PATENT SPECIFICATION

(11) **EP 2 148 378 B1**
(45) Date of publication and mention of the grant of the patent: **01.06.2011**
(21) Application number: 08013467.9
(22) Date of filing: 25.07.2008
(51) Int. Cl.: H01L 31/072, H01L 31/068, H01L 31/18

(54) **Barrier layers in inverted metamorphic multijunction solar cells**
Sperrschichten in umgekehrten metamorphischen Multiverbindungssolarzellen
Couches barrière dans des cellules solaires métamorphiques multijonctions inversées

(43) Date of publication of application: 27.01.2010
(73) Proprietor: Emcore Solar Power, Inc., Albuquerque NM 87123 (US)
(72) Inventor: Cornfeld, Arthur, Albuquerque, New Mexico 87047 (US); Stan, Mark A., c/o Emcore Corporation, Albuquerque, New Mexico 87122 (US); Varghese, Tansen, Albuquerque, New Mexico 87111 (US); Newman, Fred, c/o Emcore Corporation, Albuquerque, New Mexico 87108 (US)
(74) Representative: Wagner, Karl H.

(56) References cited:
- EP-A- 1 939 945
- US-A1- 2004 166 681
- US-A1- 2007 277 873

## Description

### BACKGROUND OF THE INVENTION

### 1. Field of the Invention

The present invention relates to the field of solar cell semiconductor devices, and particularly to multijunction solar cells including metamorphic layers. Such devices also include inverted metamorphic solar cells.

### 2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated, solar cells, which act as the power conversion devices for the on-board power systems, become increasingly more important.

Solar cells are often fabricated in vertical, multifunction structures, and disposed in horizontal arrays, with the individual solar cells connected together in a series. The shape and structure of an array, as well as the number of cells it contains, are determined in part by the desired output voltage and current.

Inverted metamorphic solar cell structures such as described in M.W. Wanlass et al., Lattice Mismatched Approaches for High Performance, III-V Photovoltaic Energy Converters (Conference Proceedings of the 31st IEEE Photovoltaic Specialists Conference, Jan. 3-7, 2005, IEEE Press, 2005) present an important starting point for the development of future commercial high efficiency solar cells. The structures described in such prior art present a number of practical difficulties relating to the appropriate choice of materials and fabrication steps, in particular associated with the lattice mis-matched layers between the "lower" subcell (the subcell with the lowest band gap) and the adjacent subcell. Prior to the present invention, the materials and fabrication steps disclosed in the prior art have not been adequate to produce a commercially viable and energy efficient solar cell using an inverted metamorphic cell structure. In particular, threading dislocations propagating from the metamorphic layers present a processing challenge.

A metamorphic layer deposited over a barrier layer is known from US 2007/0277873 in an inverted metamorphic solar cell structure.

### SUMMARY OF THE INVENTION

The present invention is defined by a method according to claim 1, and devices according to claims 15 and 22.

### BRIEF DESCRIPTION OF THE DRAWINGS

The invention will be better and more fully appreciated by reference to the following detailed description when considered in conjunction with the accompanying drawings, wherein:

FIG. 1 is an enlarged cross-sectional view of a solar cell constructed according to the present invention;

FIG. 2 is a cross-sectional view of the solar cell of FIG. 1 after the next process step;

FIG. 3 is a cross-sectional view of the solar cell of FIG. 2 after the next process step;

FIG. 4 is a cross-sectional view of the solar cell of FIG. 3 after the next process step;

FIG. 5A is a cross-sectional view of the solar cell of FIG. 4 after the next process step in which the original substrate is removed;

FIG. 5B is another cross-sectional view of the solar cell of FIG. 5A with the surrogate substrate on the bottom of the Figure;

FIG. 6A is a top plan view of a wafer in which the solar cells are fabricated;

FIG. 6B is a bottom plan view of a wafer in which the solar cells are fabricated;

FIG. 7 is a top plan view of the wafer of FIG. 6B after the next process step;

FIG. 8 is a cross-sectional view of the solar cell of FIG. 5A after the next process step;

FIG. 9 is a cross-sectional view of the solar cell of FIG. 8 after the next process step;

FIG. 10 is a cross-seetional view of the solar cell of FIG. 9 after the next process step;

FIG. 11 is a cross-sectional view of the solar cell of FIG. 10 after the next process step;

FIG. 12 is a cross-sectional view of the solar cell of FIG. 11 after the next process step;

FIG. 13 is a cross-sectional view of the solar cell of FIG. 12 after the next process step;

FIG. 14 is a cross-sectional view of the solar cell of FIG. 13 after the next process step;

FIG. 15 is a cross-sectional view of the solar cell of FIG. 14 after the next process step;

FIG. 16 is an external quantum efficiency (EQE) graph of inverted metamorphic solar cell without barrier layers according to the present invention;

FIG. 17 is an EQE graph of the middle solar subcell with and without barrier layers; and

FIG. 18 is an EQE graph of an inverted metamorphic solar cell with barrier layers according to the present invention.

### DESCRIPTION OF THE PRIOR ART AND PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

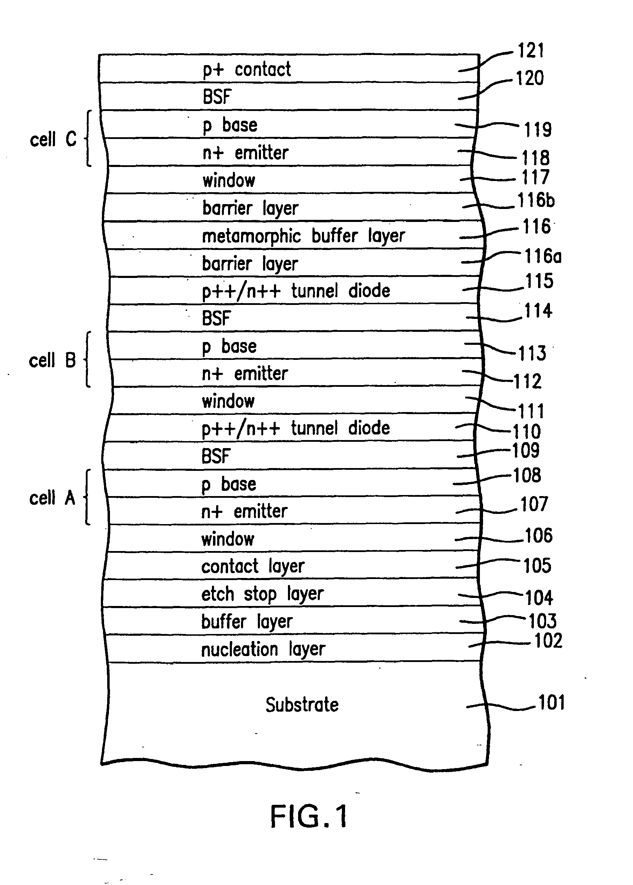

FIG. 1 depicts the multijunction solar cell according to the present invention after formation of the three subcells A, B and C on a substrate. More particularly, there is shown a substrate 101, which may be either gallium arsenide (GaAs), germanium (Ge), or other suitable material. In the case of a Ge substrate, a nucleation layer 102 is deposited on the substrate. On the substrate, or over the nucleation layer 102, a buffer layer 103, and an etch stop layer 104 are further deposited. A contact layer 105 is then deposited on layer 104, and a window layer 106 is deposited on the contact layer. The subcell A, consisting of an n+ emitter layer 107 and a p-type base layer 108, is then deposited on the window layer 106.

It should be noted that the multijunction solar cell structure could be formed by any suitable combination of group III to V elements listed in the periodic table subject to lattice constant and band gap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In the preferred embodiment, the emitter layer 107 is composed of InQa(Al)P and the base layer is composed of InGa(Al)P.

The A1 term in parenthesis means that A1 is an optional constituent, and in this instance may be used in an amount ranging from 0% to 30%.

On top of the base layer 108 is deposited a back surface field ("BSF") layer 109 used to reduce recombination loss.

The BSF layer 109 drives minority carriers from the region near the base/BSF interface surface to minimize the effect of recombination loss. In other words, a BSF layer 109 reduces recombination loss at the backside of the solar subcell A and thereby reduces the recombination in the base.

On top of the BSF layer 109 is deposited a sequence of heavily doped p-type and n-type layers 110 which forms a tunnel diode which is a circuit element to connect subcell A to subcell B.

On top of the tunnel diode layers 110 a window layer 111 is deposited. The window layer 111 used in the subcell B also operates to reduce the recombination loss. The window layer 111 also improves the passivation of the cell surface of the underlying junctions. It should be apparent to one skilled in the art, that additional layer(s) may be added or deleted in the cell structure without departing from the scope of the present invention.

On top of the window layer 111 the layers of cell B are deposited: the emitter layer 112, and the p-type base layer 113. These layers are preferably composed of InGaP and Ga(In)As respectively, although any other suitable materials consistent with lattice constant and band gap requirements may be used as well.

On top of the cell B is deposited a BSF layer 114 which performs the same function as the BSF layer 109. A p++/n++ tunnel diode 115 is deposited over the BSF layer 114 similar to the layers 110, again forming a circuit element to connect cell B to cell C.

A barrier layer 116a, preferably composed of InGa(Al)P, is deposited over the tunnel diode 115, to a thickness of about 1.0 micron. Such barrier layer is intended to prevent threading dislocations from propagating, either opposite to the direction of growth into the middle and top subcells B and A, or in the direction of growth into the bottom subcell C. The barrier layer may be any combination of III - V compound semiconductor layers having a bandgap energy greater than or equal to the grading interlayer 116, and a thickness sufficient to reduce the propagation of threading dislocations. Typical materials are As, P, N or Sb based III - V semiconductor materials.

A grading interlayer or metamorphic layer 116 is deposited over the barrier layer 116a. Layer 116 is preferably a compositionally step-graded series of InGaAlAs layers with monotonically changing lattice constant that is intended to achieve a transition in lattice constant from subcell B to subcell C. The band gap of layers 116 is 1.5 eV consistent with a value slightly greater than the band gap of the middle subcell B.

A grading interlayer may be composed of any of the As, P, N, Sb based III - V compound semiconductors subject to the constraints of having the in-plane lattice parameter greater or equal to that of the second solar cell B and less than or equal to that of the third solar cell C, and having a bandgap energy greater than that of the second solar cell B.

In one embodiment, as suggested in the Wanlass et al. paper, the step grade contains nine compositionally graded InGaP steps with each step layer having a thickness of 0.25 micron. In the preferred embodiment, the layer 116 is composed of InGaAlAs, with monotonically changing lattice constant, over at least nine steps.

In the present invention, a second barrier layer 116b is deposited over the InGaAlAs metamorphic layer 116. The second barrier layer 116b will have a different composition than that of barrier layer 116a, and again the base region may be GalnAs, GaAsSb, or GaInAsN.

A window layer 117 is deposited over the barrier layer 116b, this window layer operating to reduce the recombination loss in subcell "C". It should be apparent to one skilled in the art that additional layers may be added or deleted in the cell structure without departing from the scope of the present invention.

On top of the window layer 117, the layers of cell C are deposited: the n+ emitter layer 118, and the p-type base layer 119. These layers are preferably composed of InGaP and Ga(In)As respectively, although another suitable materials consistent with lattice constant and band gap requirements may be used as well.

A BSF layer 120 is deposited on top of the cell C, the BSF layer performing the same function as the BSF layers 109 and 114.

Finally ap+ contact layer 121 is deposited on the BSF layer 120.

It should be apparent to one skilled in the art, that additional layer(s) may be added or deleted in the cell structure without departing from the scope of the present invention.

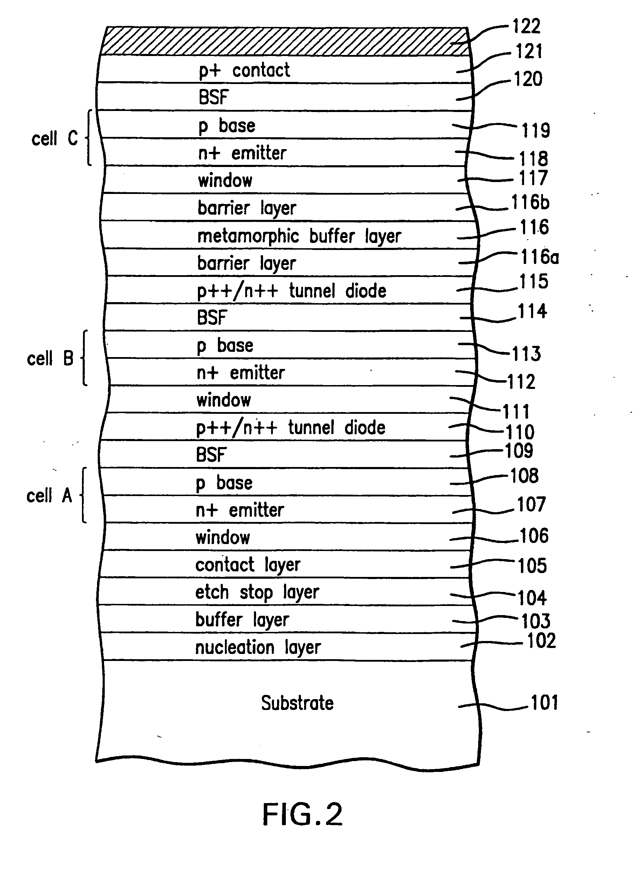

FIG. 2 is a cross-sectional view of the solar cell of FIG. 1 after the next process step in which a metal contact layer 122 is deposited over the p+ semiconductor contact layer 121. The metal is preferably Ti/Au/Ag/Au.

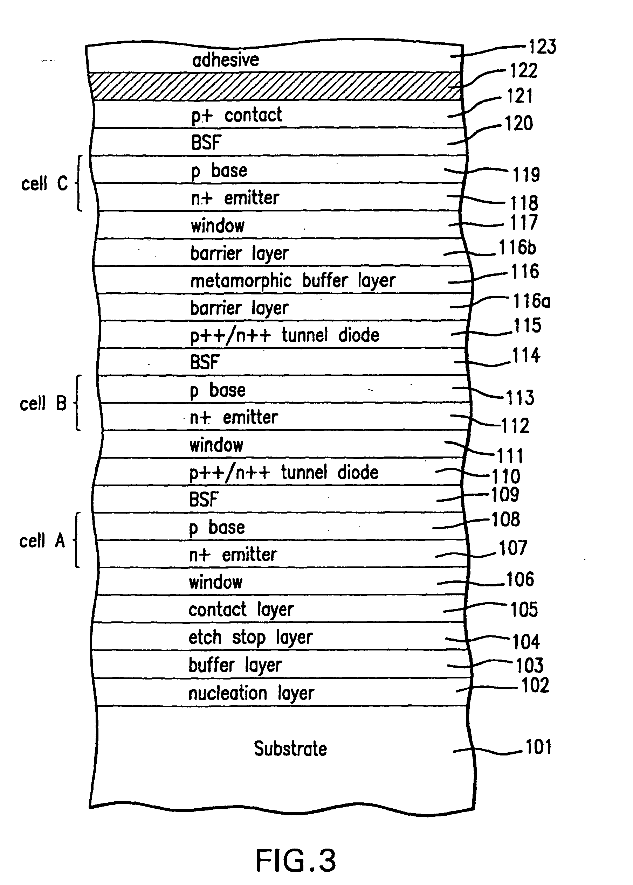

FIG. 3 is a cross-sectional view of the solar cell of FIG. 2 after the next process step in which an adhesive layer 123 is deposited over the metal layer 122. The adhesive is preferably GenTak 330 (distributed by General Chemical Corp.).

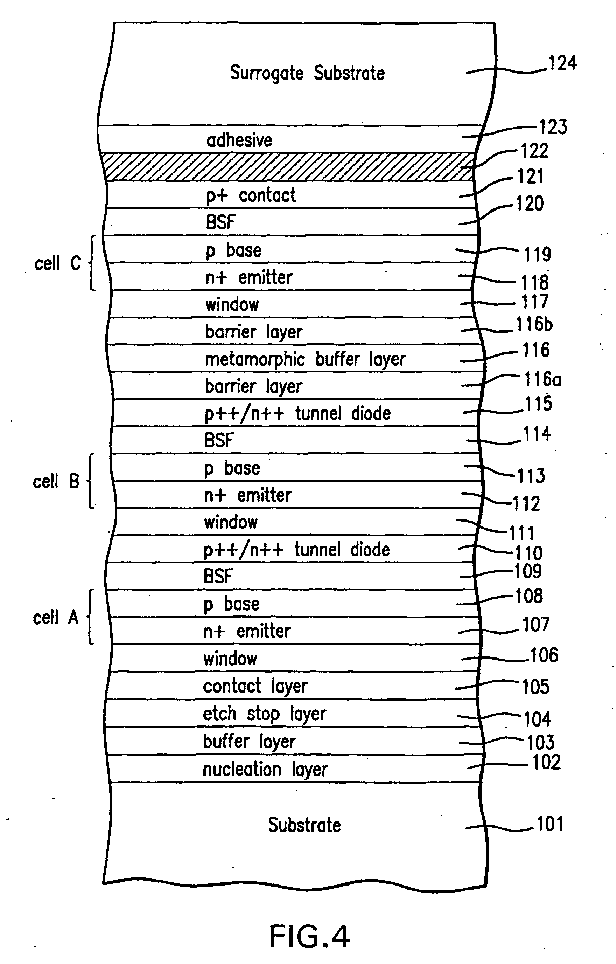

FIG. 4 is a cross-sectional view of the solar cell of FIG. 3 after the next process step in which a surrogate substrate, preferably sapphire, is attached. The surrogate substrate is about 40 mils in thickness, and is perforated with holes about 1mm in diameter, spaced 4mm apart, to aid in subsequent removal of the adhesive and the substrate.

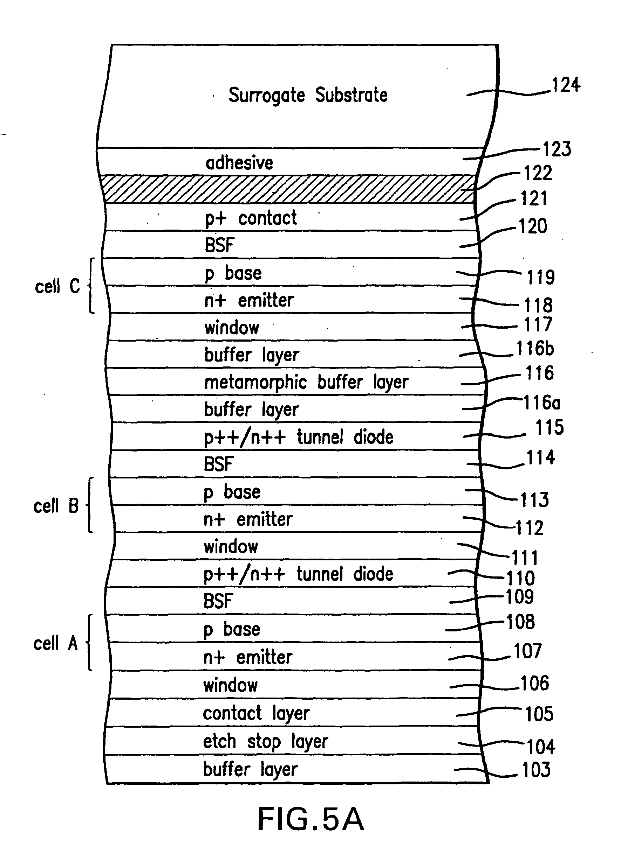

FIG. 5A is a cross-sectional view of the solar cell of FIG. 4 after the next process step in which the original substrate is removed by a sequence of lapping and/or etching steps in which the substrate 101, the buffer layer 103, and the etch stop layer 104, are removed. The etchant is growth substrate dependent.

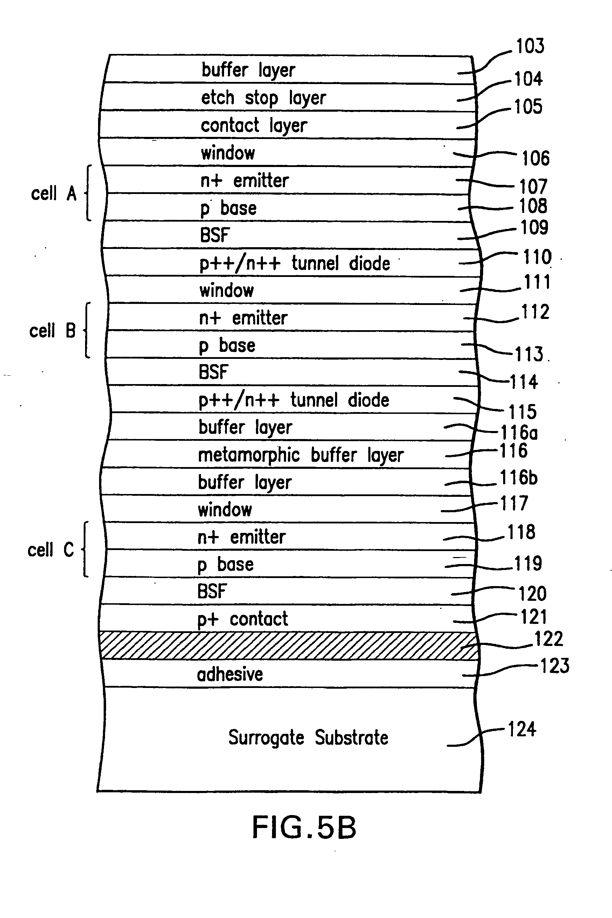

FIG. 5B is a cross-sectional view of the solar cell of FIG. 5A from the solar cell of FIG. 5A from the orientation with the surrogate substrate 124 being at the bottom of the Figure.

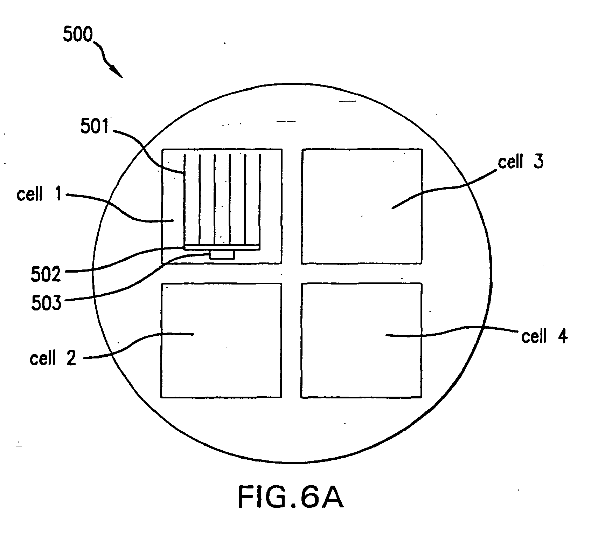

FIG. 6A is a top plan view of a wafer in which the solar cells are implemented.

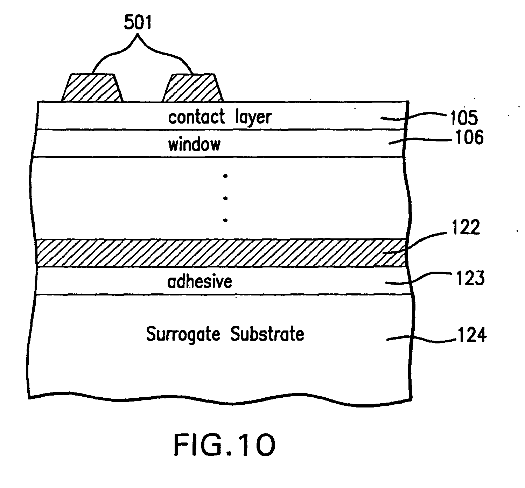

In each cell there are grid lines 501 (more particularly shown in cross-section in FIG. 10), an interconnecting bus line 502, and a contact pad 503.

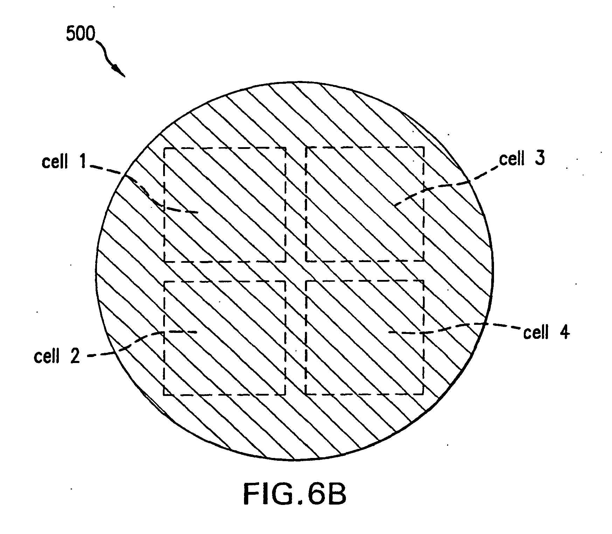

FIG. 6B is a bottom plan view of the wafer with four solar cells shown in FIG. 6A.

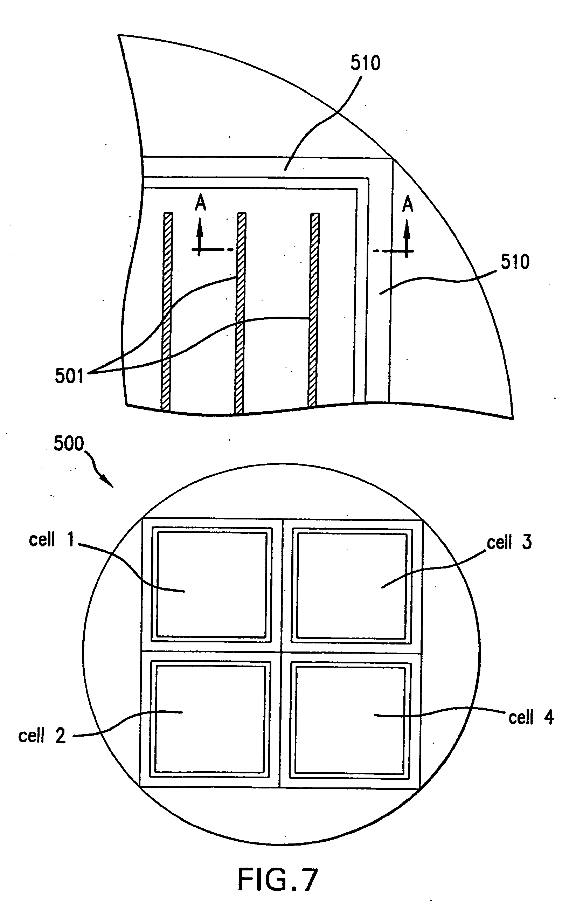

FIG. 7 is a top plan view of the wafer of FIG. 6A after the next process step in which a mesa 510 is etched around the periphery of each cell using phosphide and arsenide etchants.

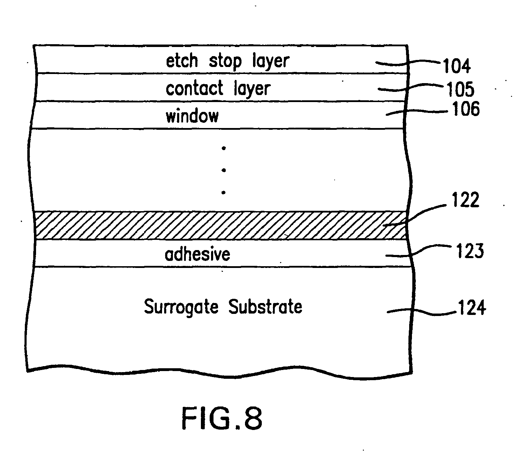

FIG. 8 is a simplified cross-sectional view of the solar cell of FIG. 5B depicting just a few of the top layers and lower layers over the surrogate substrate 124.

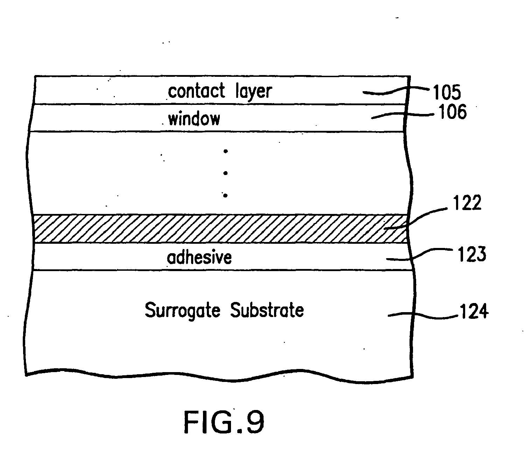

FIG. 9 is a cross-sectional view of the solar cell of FIG. 8 after the next process step in which the etch stop layer 104 is removed by a HCl/H₂O solution.

FIG. 10 is a cross-sectional view of the solar cell of FIG. 9 after the next sequence of process steps in which a photoresist mask (not shown) is placed over the contact layer 105 to form the grid lines 501. The grid lines 501 are deposited via evaporation and lithographically patterned and deposited over the contact layer 105. The mask is lifted off to form the metal grid lines 501.

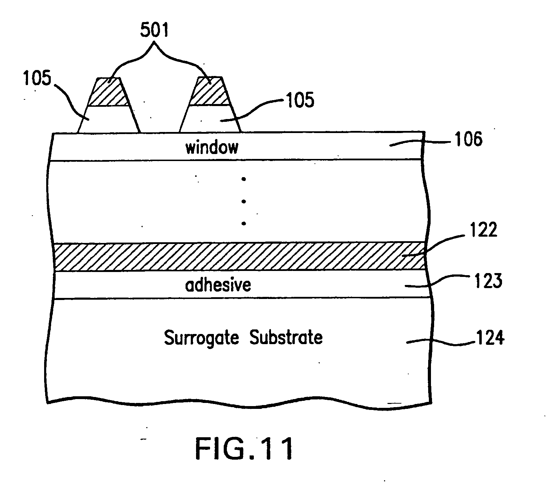

FIG. 11 is a cross-sectional view of the solar cell of FIG. 10 after the next process step in which the grid lines are used as a mask to etch down the surface to the window layer 106 using a citric acid/peroxide etching mixture.

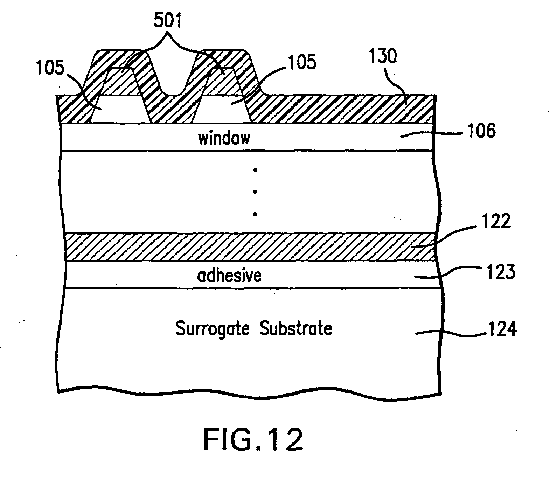

FIG. 12 is a cross-sectional view of the solar cell of FIG. 11 after the next process step in which an antireflective (ARC) dielectric coating layer 130 is applied over the entire surface of the "bottom" side of the wafer with the grid lines 501.

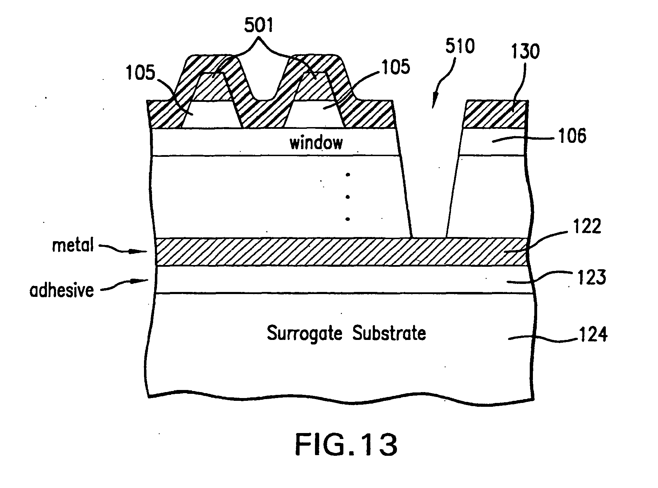

FIG. 13 is a cross-sectional view of the solar cell of FIG. 12 after the next process step in which the mesa 501 is etched down to the metal layer 122 using phosphide and arsenide etchants. The cross-section in the figure is depicted as seen from the A-A plane shown in FIG. 7. One or more silver electrodes are then welded to the contact pad(s).

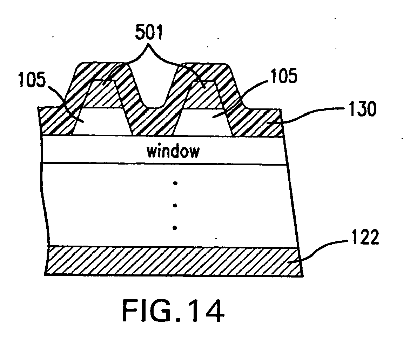

FIG. 14 is a cross-sectional view of the solar cell of FIG. 13 after the next process step after the surrogate substrate 124 and adhesive 123 are removed by EKC 922. The preferred perforations provided in the surrogate substrate have a diameter of 0.033 inches, and are separated by 0.152 inches.

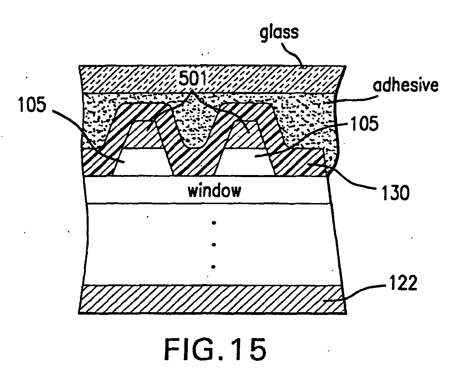

FIG. 15 is a cross-sectional view of the solar cell of FIG. 14 after the next process step in which an adhesive is applied over the ARC layer 130 and a coverglass attached thereto.

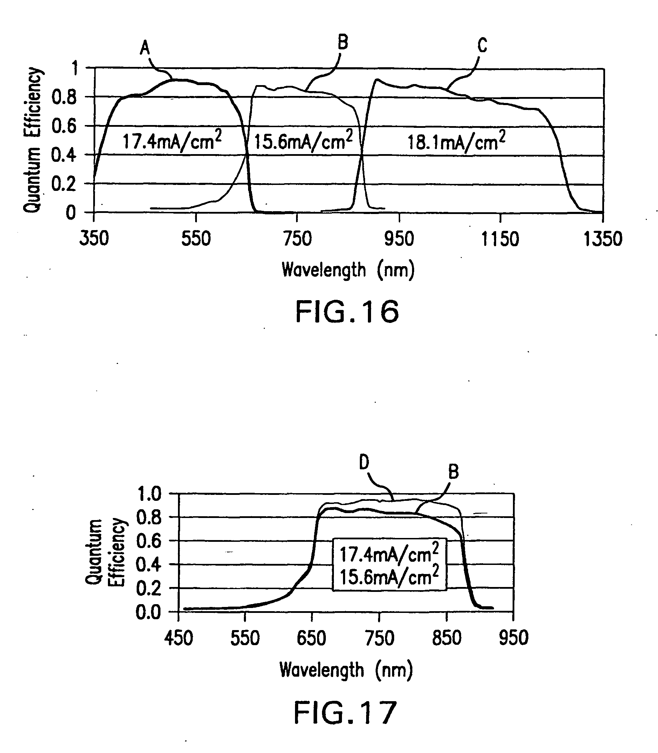

Experimented indication of the efficacy of the present invention is provided in FIGs. 16 through 18. A structure of the type shown in FIG. 1 but without barrier layers 116a and 116b was grown and fabricated into 4 cm² cells. External quantum efficiency (EQE) measurements were made and the results shown in FIG. 16 indicate that the long wavelength response of the middle subcell B was lower than expected. This observation suggested that threading dislocation propagation opposite to the direction of growth may be responsible for the degradation in the efficiency of the middle cell. Nomarski microscopy indicated unexpected cross-hatching (a mode of strain relief) on the initial epitaxial layer of the lattice matched subcell A. Photoluminescence mapping further revealed that the luminescence of the middle subcell B was lower than expected. Cathodoluminescence measurements indicated that the threading dislocation density was high in the middle subcell B, but the threading dislocations did not penetrate the top subcell A. These measurements were consistent with the EQE measurements shown in FIG. 16.

FIG. 17 illustrates a comparison of the EQE measurements of a middle subcell in a triple junction solar cell with and without the addition of the barrier layer 116a according to the present invention. The graph of subcell B (without the barrier layer) has an integrated current (AMO) of 15.6 mA/cm² and lower EQE than that of subcell D (with the barrier layer), has an integrated current AMO) of 17.4 mA/cm².

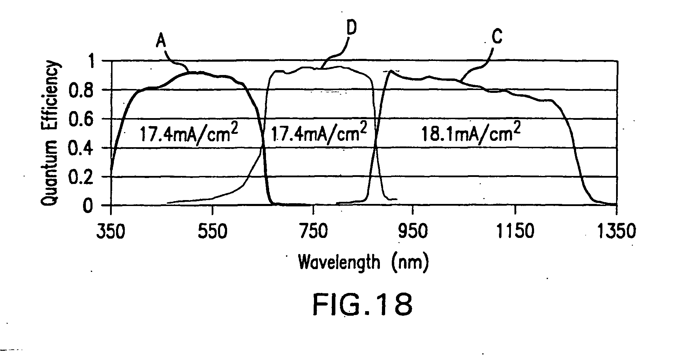

The efficacy of the use of a barrier layer in the solar cell of the present invention can be appreciated from comparing the EQE graphs of Figures 16 and 18. Figure 16 is an EQE for the solar cell of FIG, 1 without a barrier layer, and Figure 18 is an EQE for the solar cell with a barrier layer. The current of the middle subcell B of the solar cell of Figure 18 (17.4 mA/cm²) is only slightly below the current of the top subcell C (18.4 mA/cm²). Such close current matching of the middle subcell and the top subcell demonstrates the efficacy of the present invention.

It will be understood that each of the elements described above, or two or more together, also may find a useful application in other types of constructions differing from the types of constructions described above.

Although the preferred embodiment of the present invention utilizes a vertical stack of subcells with top and bottom electrical contacts, the subcells may alternatively be contacted by means of metal contacts to laterally conductive semiconductor layers between the subcells. Such arrangements may be used to form 3-terminal, 4-terminal, and in general, n-terminal devices. The subcells can be interconnected in circuits using these additional terminals such that most of the available photogenerated current density in each subcell can be used effectively, leading to high efficiency for the multijunction cell, notwithstanding that the photogenerated current densities are typically different in the various subcells.

As noted above, the present invention may utilize one or more homojunction cells or subcells, i.e., a cell or subcell in which the p-n junction is formed between a p-type semiconductor and an n-type semiconductors both of which have the same chemical composition and the same band gap, differing only in the dopant species and types. Subcell A, with p-type and n-type InGaP is one example of a homojunction subcell. Alternatively, the present invention may utilize one or more heterojunction cells or subcells, i.e., a cell or subcell in which the p-n junction is formed between a p-type semiconductor and an n-type semiconductor having different chemical compositions of the semiconductor material in the n-type and n-type regions, and/or different band gap energies in the p-type regions, in addition to utilizing different dopant species and type in the p-type and n-type regions that form the p-n junction.

The composition of the window or BSF layers may utilize other semiconductor compounds, subject to lattice constant and bandgap requirements, and may include AlInP, AlAs, AlP, AlGaInP. AlGaAsP, AlGaInAs, AlGaInPAs, OaInP, GaInAs, GaInPAs, AlGaAs, AlInAs, AlInPAs, GaAsSb, AlAsSb, GaAlAsSb, AlInSb, GaInSb, AlGaInSb, AIN, GaN, InN, GaInN, AlGaInN, GaInNAs, AlGaInNAs, ZnSSe, CdSSe, and similar materials, and still fall within the scope of the present invention.

While the invention has been illustrated and described as embodied in a inverted metamorphic multijunction solar cell, it is not intended to be limited to the details shown, since various modifications and structural changes may be made without departing in any way from the scope of the present invention.

Without further analysis, the foregoing will so fully reveal the gist of the present invention that others can, by applying current knowledge, readily adapt it for various applications without omitting features that, from the standpoint of prior art, fairly constitute essential characteristics of the generic or specific aspects of this invention and, therefore, such adaptations should and are intended to be comprehended within the meaning and range of equivalence of the following claims.

## Claims

1. A method of forming a multijunction solar cell comprising an upper subcell (C), a middle subcell (B), and a lower subcell (A), the method comprising in the following order:
providing first substrate (101) for the epitaxial growth of semiconductor material;
forming a first solar subcell (A) on said substrate having a first band gap;
forming a second solar subcell (B) over said first solar subcell (A) having a second band gap smaller than said first band gap;
forming a first barrier layer (116a) over said second subcell (B);
forming a grading interlayer (116) over said barrier layer (116a), said grading interlayer (116) having a third band gap greater than said second band gap;
forming a second barrier layer (116b) over said grading interlayer (116); and
forming a third solar subcell (C) over said grading interlayer (116) having a fourth band gap smaller than said second band gap such that said third subcell (C) is lattice mismatched with respect to said second subcell (B).
**characterized in that**
said first (116a) and second (116b) barrier layers are composed of any As, P, N, or Sb based III - V compound semiconductors
with said second barrier layer (116b) having a different composition than that of said first barrier layer (116a); and
said first (116a) and second (116b) barrier layers are composed of suitable material and lattice constant to prevent threading dislocations from propagating.

2. A method as defined in claim 1, wherein said first barrier layer (116a) has a bandgap energy greater than or equal to that of the grading interlayer.

3. A method as defined in claim 1, wherein said second barrier layer (116b) has a bandgap energy greater than or equal to that of the first grading interlayer (116a).

4. A method as defined in claim 1, wherein said first substrate (101) is selected from the group consisting of germanium or GaAs.

5. A method as defined in claim 1, wherein said first solar subcell (A) is composed of an InGa(Al)P emitter region and an InGa(Al)P base region.

6. A method as defined in claim 5, wherein said second solar cell (B) is composed of an GaInP, GaInAs, GaAsSb, or GaInAsN emitter region and an GaInAs, GaAsSb, or GaInAsN base region.

7. A method as defined in claim 1, wherein said grading interlayer (116) is composed of any of the As, P, N, Sb based III - V compound semiconductors subject to the constraints of having the in-plane lattice parameter greater or equal to that of the second solar cell (B) and less than or equal to that of the third solar cell (C), and having a bandgap energy greater than that of the second solar cell (B).

8. A method as defined in claim 5 wherein said second solar subcell (B) is composed of an InGaP emitter region and an GaAs base region.

9. A method as defined in claim 1, wherein said grading interlayer (116) is composed of InGaAlAs.

10. A method as defined in claim 7, wherein said grading interlayer (116) is composed of nine steps of layers with monotonically changing lattice constant.

11. A method as defined in claim 1, further comprising depositing a contact layer (121) over said third solar subcell (C) and making electrical contact therewith.

12. A method as defined in claim 9, further comprising attacking a surrogate second substrate (124) over said contact layer (121) and removing the first substrate (101).

13. A method as defined in claim 1, further comprising:
patterning a contact layer (105) into a grid; and
etching a trough around the periphery of said solar cell so as to form a mesa structure on said surrogate second substrate (124).

14. A multijunction solar cell comprising:
a substrate (101);
a first solar subcell (A) on said substrate (101) having a first band gap;
a second solar subcell (B) disposed over said first subcell (A) and having a second band gap smaller than said first band gap;
a first barrier layer (116a) disposed over said second subcell (B);
a grading interlayer (116) disposed over said first barrier layer (116a) and having a third band gap greater than said second band gap;
a second barrier layer (116b) over said grading layer (116); and
a third solar subcell (C) disposed over said grading interlayer (116) that is lattice mismatched with respect to said second subcell (B) and having a fourth band gap smaller than said second band gap, said solar cell being
**characterized in that**
said first (116a) and second (116b) barrier layers are composed of any As, P, N, or Sb based III - V compound semiconductors with said second barrier layer (116b) having a different composition than that of said first barrier layer (116a); and
said first (116a) and second (116b) barrier layers are composed of suitable material and lattice constant to prevent threading dislocations from propagating.

15. A solar cell as defined in claim 14, wherein said barrier layer (116a) has a bandgap energy greater than or equal to that of the grading intarlayer (116).

16. A solar cell as defined in claim 14, wherein said second barrier layer (116b)
has a bandgap energy greater than or equal to that of the grading interlayer(116).

17. A solar cell as defined in claim 14, wherein the substrate (101) is selected from the group consisting of germanium or GaAs.

18. A solar cell as defined in claim 14, wherein said first solar subcell (A) is composed of InGa(Al)P.

19. A solar cell as defined in claim 14, wherein said second solar subcell (B) is composed of an GaInP, GaInAg, GaAsSb, or GaInAsN emitter region and an GaInAs, GaAsSb, or GaInAsN base region.

20. A solar cell as defined in claim 14, wherein said third solar subcell (C) is composed of InGaAs.

## Patentansprüche

1. Ein Verfahren zur Ausbildung einer Multijunction-Solarzelle mit einer oberen Subzelle (C), einer mittleren Subzelle (B) und einer unteren Subzelle (A), wobei das Verfahren folgende Schritte in der folgenden Reihenfolge aufweist:
Vorsehen eines ersten Substrats (101) für das Epitaxial-Wachstum des Halbleitermaterials;
Ausbildung einer ersten solaren Subzelle (A) auf dem Substrat mit einem ersten Bandabstand;
Ausbilden einer zweiten solaren Subzelle (B) über der ersten solaren Subzelle (A) mit einem zweiten Bandabstand, der kleiner ist als der erste Bandabstand;
Ausbilden einer ersten vergrabenen Schicht (Barrier-Schicht) (116a) über der zweiten Subzelle (B);
Ausbilden einer Gradier-Zwischenschicht (Schicht mit monoton sich änderndem Parameter) (116) über der vergrabenen Schicht (116a), wobei die Gradier-Zwischenschicht (116) einen dritten Bandabstand besitzt, der größer ist als der zweite Bandabstand;
Ausbilden einer zweiten vergrabenen Schicht (116b) über der erwähnten Gradier-Zwischenschicht (116) und Ausbilden einer dritten solaren Subzelle (C) über der Gradier-Zwischenschicht (116) mit einem vierten Bandabstand, der kleiner ist als der zweite Bandabstand derart, dass die dritte Subzelle (C) gitterfehlangepasst bezüglich der zweiten Subzelle (B) ist, **dadurch gekennzeichnet, dass**
die erwähnten ersten (116a) und zweiten (116b) vergrabenen Schichten aufgebaut sind aus irgendeinem der As-, P-, N- oder Sb-basierenden III-V Verbindungshalbleiter,
wobei die zweite vergrabene Schicht (116b) eine unterschiedliche Zusammensetzung gegenüber derjenigen der ersten vergrabenen Schicht (116a) besitzt; und
wobei die erste vergrabene Schicht (116a) und die zweite vergrabene Schicht (116b) aufgebaut sind aus einem geeigneten Material und Gitterkonstante zur Verhinderung der Fortpflanzung von fadenförmigen bzw. Durchsetzungs-Versetzungen (threading dislocations).

2. Verfahren nach Anspruch 1, wobei die erste vergrabene Schicht (116a) eine Bandabstands- bzw. Bandkantenenergie besitzt, die größer ist als oder gleich der der Gradier-Zwischenschicht.

3. Verfahren nach Anspruch 1, wobei die zweite vergrabene Schicht (116b) eine Bandabstandsenergie besitzt, die größer ist als oder gleich der der ersten Gradier-Zwischenschicht (116a).

4. Verfahren nach Anspruch 1, wobei das erste Substrat (101) aus der Gruppe ausgewählt ist, die aus Germanium oder GaAs besteht.

5. Verfahren nach Anspruch 1, wobei die erwähnte erste solare Subzelle (A) aufgebaut ist aus einer InGa(Al)P Emitterzone (Emitterbereich) und einer InGa(Al)P-Basiszone (Basisbereich).

6. Verfahren nach Anspruch 5, wobei die zweite Solarzelle (B) aufgebaut ist aus einer GaInP, GaInAs, GaAsSb oder GaInAsN Emitterzone und einer GaInAs, GaAsSb oder GaInAsN Basiszone.

7. Verfahren nach Anspruch 1, wobei die Gradier-Zwischenschicht (116) aufgebaut ist aus irgendeinem der As-, P-, N-, Sb-basierenden III-V Verbindungshalbleiter und zwar unter Berücksichtigung der Einschränkungen, dass der "In-Ebene"-Gitterparameter größer ist oder gleich dem der zweiten Solarzelle (B) und kleiner als oder gleich dem der dritten Solarzelle (C) und mit einer Bandabstands- bzw. Bandkantenenergie größer als der der zweiten Solarzelle (B).

8. Verfahren nach Anspruch 5, wobei die zweite solare Subzelle (B) aufgebaut ist aus einer InGaP Emitterzone und einer GaAs Basiszone.

9. Verfahren nach Anspruch 1, wobei die Gradier-Zwischenschicht (116) aufgebaut ist aus InGaAIAs.

10. Verfahren nach Anspruch 7, wobei die Gradier-Zwischenschicht (116) aufgebaut ist aus neun Stufen von Schichten mit sich monoton ändernder Gitterkonstanten.

11. Verfahren nach Anspruch 1, wobei ferner eine Kontaktschicht (121) über der dritten solaren Subzelle (C) abgeschieden ist und elektrischen Kontakt damit vorsieht.

12. Verfahren nach Anspruch 9, wobei ein zweites Surrogat-Substrat (124) über der Kontaktschicht (121) angebracht ist und das erste Substrat (101) entfernt wird.

13. Verfahren nach Anspruch 1, wobei ferner Folgendes vorgesehen ist:
Mustern einer Kontaktschicht (105) in ein Gitter; und
Ätzen eines Trogs um den Umfand der Solarzelle herum, um so eine Mesa-Struktur auf dem zweiten Surrogat-Substrat (124) zu bilden.

14. Eine Multijunction-Solarzelle, die Folgendes aufweist:
ein Substrat (101);
eine erste solare Subzelle (A) auf dem Substrat (101) mit einem ersten Bandabstand;
eine zweite solare Subzelle (B), angeordnet über der ersten Subzelle (A) und mit einem zweiten Bandabstand, der kleiner ist als der erste Bandabstand;
eine erste vergrabene Schicht (116a), angeordnet über der zweien Subzelle (B);
eine Gradier-Zwischenschicht (116), angeordnet über der ersten vergrabenen Schicht (116a) und mit einem dritten Bandabstand, der größer ist als der zweite Bandabstand;
eine zweite vergrabene Schicht (116b) über der Gradierschicht (116); und
eine dritte solare Subzelle (C), angeordnet über der erwähnten Gradier-Zwischenschicht (116), die gitterfehlangepasst ist bezüglich der zweiten Subzelle (B) und einem vierten Bandabstand hat, der kleiner ist als der zweite Bandabstand,
wobei die Solarzelle **dadurch gekennzeichnet ist, dass** die erste vergrabene Schicht (116a) und die zweite vergrabene Schicht (116b) aufgebaut sind aus irgendeinem der As-, P-, N- oder Sb-basierenden III-V Verbindungshalbleiter,
wobei die zweite vergrabene Schicht (116b) eine unterschiedliche Zusammensetzung besitzt als die der ersten vergrabenen Schicht (116a); und
die erste vergrabene Schicht (116a) und die zweite vergrabene Schicht (116b) aufgebaut sind aus einem geeigneten Material und mit geeigneten Gitterkonstanten, um die Fortpflanzung fadenförmiger Versetzungen von (threading dislocations) zu verhindern.

15. Eine Solarzelle nach Anspruch 14, wobei die vergrabene Schicht (116a) eine Bandabstands- bzw. Bandkantenenergie besitzt, die größer ist als oder gleich der der Gradier-Zwischenschicht (116).

16. Eine Solarzelle nach Anspruch 14, wobei die zweite Sperrschicht (116b) eine Bandabstandsenergie besitzt, die größer ist als oder gleich der der Gradier-Zwischenschicht (116).

17. Eine Solarzelle nach Anspruch 14, wobei das Substrat (101) ausgewählt ist aus der aus Germanium oder GaAs bestehenden Gruppe.

18. Eine Solarzelle nach Anspruch 14, wobei die erste solare Subzelle (A) aufgebaut ist aus InGa(AI)P.

19. Eine Solarzelle nach Anspruch 14, wobei die zweite solare Subzelle (B) aufgebaut ist aus einer GaInP, GaInAs, GaAsSb oder GaInAsN Emitterzone und einer GaInAs, GaAsSb oder GaInAsN Basiszone.

20. Eine Solarzelle nach Anspruch 14, wobei die dritte solare Subzelle (C) aufgebaut ist aus InGaAs.

## Revendications

1. Procédé de formation d'une cellule solaire à jonctions multiples comprenant une sous-cellule supérieure (C), une sous-cellule médiane (B) et une sous-cellule inférieure (A), le procédé consistant à, dans l'ordre suivant :
fournir un premier substrat (101) pour la croissance épitaxiale d'un matériau semiconducteur ;
former une première sous-cellule solaire (A) sur ledit substrat ayant une première bande interdite ;
former une seconde sous-cellule solaire (B) sur ladite première sous-cellule solaire (A) ayant une seconde bande interdite inférieure à ladite première bande interdite ;
former une première couche barrière (116a) sur ladite seconde sous-cellule (B) ;
former une intercouche de gradation (116) sur ladite couche barrière (116a), ladite intercouche de gradation (116) ayant une troisième bande interdite supérieure à ladite seconde bande interdite ;
former une seconde couche barrière (116b) sur ladite intercouche de gradation (116) ; et
former une troisième sous-cellule solaire (C) sur ladite intercouche de gradation (116) ayant une quatrième bande interdite inférieure à ladite seconde bande interdite de façon que ladite troisième sous-cellule (C) présente une désadaptation de réseau par rapport à ladite seconde sous-cellule (B),
**caractérisé en ce que**
lesdites première (116a) et seconde (116b) couches barrières sont composées de semiconducteurs composites quelconques de type III-V à base d'As, P, N ou Sb, ladite seconde couche barrière (116b) ayant une composition différente de ladite première couche barrière (116a) ; et
lesdites première (116a) et seconde (116b) couches barrières sont composées d'un matériau approprié et ont une constante de réseau permettant d'éviter la propagation de dislocations émergentes.

2. Procédé selon la revendication 1, dans lequel ladite première couche barrière (116a) a une énergie de bande interdite supérieure ou égale à celle de l'intercouche de gradation.

3. Procédé selon la revendication 1, dans lequel ladite seconde couche barrière (116b) a une énergie de bande interdite supérieure ou égale à celle de la première intercouche de gradation (116a).

4. Procédé selon la revendication 1, dans lequel ledit premier substrat (101) est sélectionné dans le groupe constitué du germanium ou du GaAs.

5. Procédé selon la revendication 1, dans lequel ladite première sous-cellule solaire (A) est composée d'une région d'émetteur d'InGa(Al)P et d'une région de base d'InGa(Al)P.

6. Procédé selon la revendication 5, dans lequel ladite seconde cellule solaire (B) est composée d'une région d'émetteur de GaInP, de GaInAs, de GaAsSb ou de GaInAsN et d'une région de base de GaInAs, de GaAsSb ou de GaInAsN.

7. Procédé selon la revendication 1, dans lequel ladite intercouche de gradation (116) est composée de l'un quelconque des semiconducteurs composites III-V à base d'As, P, N, Sb soumis aux contraintes consistant à avoir un paramètre de réseau dans le plan supérieur ou égal à celui de la seconde cellule solaire (B) et inférieur ou égal à celui de la troisième cellule solaire (C), et ayant une énergie de bande interdite supérieure à celle de la seconde cellule solaire (B).

8. Procédé selon la revendication 5, dans lequel ladite seconde sous-cellule solaire (B) est composée d'une région d'émetteur d'InGaP et d'une région de base de GaAs.

9. Procédé selon la revendication 1, dans lequel ladite intercouche de gradation (116) est composée d'InGaAlAs.

10. Procédé selon la revendication 7, dans lequel ladite intercouche de gradation (116) est composée de neuf gradins de couches ayant des constantes de réseau variant de manière monotone.

11. Procédé selon la revendication 1, consistant en outre à déposer une couche de contact (121) sur ladite troisième sous-cellule solaire (C) et à établir un contact électrique avec celle-ci.

12. Procédé selon la revendication 9, consistant en outre à fixer un second substrat de substitution (124) sur ladite couche de contact (121) et à enlever le premier substrat (101).

13. Procédé selon la revendication 1, consistant en outre à :
mettre sous la forme d'un motif de grille une couche de contact (105) ; et
graver un puits le long de la périphérie de ladite cellule solaire de façon à former une structure de mesa sur ledit second substrat de substitution (124).

14. Cellule solaire à jonctions multiples comprenant :
un substrat (101) ;
une première sous-cellule solaire (A) sur ledit substrat (101) ayant une première bande interdite ;
une seconde sous-cellule solaire (B) disposée sur ladite première sous-cellule (A) et ayant une seconde bande interdite inférieure à ladite première bande interdite ;
une première couche barrière (116a) disposée sur ladite seconde sous-cellule (B) ;
une intercouche de gradation (116) disposée sur ladite première couche barrière (116a) et ayant une troisième bande interdite supérieure à ladite seconde bande interdite ;
une seconde couche barrière (116b) sur ladite intercouche de gradation (116) ; et
une troisième sous-cellule solaire (C) disposée sur ladite intercouche de gradation (116) qui présente une désadaptation de réseau par rapport à ladite seconde sous-cellule (B) et ayant une quatrième bande interdite inférieure à ladite seconde bande interdite, ladite cellule solaire étant **caractérisée en ce que** :
lesdites première (116a) et seconde (116b) couches barrières sont composées de semiconducteurs composites quelconques de type III-V à base d'As, P, N ou Sb, ladite seconde couche barrière (116b) ayant une composition différente de celle de ladite première couche barrière (116a) ; et
lesdites première (116a) et seconde (116b) couches barrières sont composées d'un matériau approprié et ont une constante de réseau empêchant la propagation de dislocations émergentes.

15. Cellule solaire selon la revendication 14, dans laquelle ladite couche barrière (116a) a une énergie de bande interdite supérieure ou égale à celle de l'intercouche de gradation (116).

16. Cellule solaire selon la revendication 14, dans laquelle ladite seconde couche barrière (116b) a une énergie de bande interdite supérieure ou égale à celle de l'intercouche de gradation (116).

17. Cellule solaire selon la revendication 14, dans laquelle ledit substrat (101) est sélectionné dans le groupe constitué du germanium ou du GaAs.

18. Cellule solaire selon la revendication 14, dans laquelle ladite première sous-cellule solaire (A) est composée d'InGa(Al)P.

19. Cellule solaire selon la revendication 14, dans laquelle ladite seconde sous-cellule solaire (B) est composée d'une région d'émetteur de GaInP, de GaInAs, de GaAsSb ou de GaInAsN et d'une région de base de GaInAs, de GaAsSb ou de GaInAsN.

20. Cellule solaire selon la revendication 14, dans laquelle ladite troisième sous-cellule solaire (C) est composée d'InGaAs.
